(19) Europäisches Patentamt
European Patent Office
Office européen des brevets

(11) EP 4 671 798 A1

(12) EUROPEAN PATENT APPLICATION
published in accordance with Art. 153(4) EPC

(43) Date of publication:
31.12.2025 Bulletin 2026/01

(51) International Patent Classification (IPC):
G01R 31/396 (2019.01)    G01R 31/385 (2019.01)
G01R 31/392 (2019.01)    G01R 31/382 (2019.01)
G01R 31/52 (2020.01)     G01R 19/10 (2006.01)
G01R 19/00 (2006.01)     G01R 19/165 (2006.01)

(21) Application number: 24863314.1

(22) Date of filing: 29.08.2024

(52) Cooperative Patent Classification (CPC):
G01R 19/00; G01R 19/10; G01R 19/165;
G01R 31/382; G01R 31/385; G01R 31/392;
G01R 31/396; G01R 31/52; Y02E 60/10

(86) International application number:
PCT/KR2024/096082

(87) International publication number:
WO 2025/053735 (13.03.2025 Gazette 2025/11)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 07.09.2023 KR 20230119152

(71) Applicant: LG Energy Solution, Ltd.
Seoul 07335 (KR)

(72) Inventors:
• IN, Jeong Hyeon
  Daejeon 34122 (KR)
• KIM, Young Min
  Daejeon 34122 (KR)
• PARK, Jung Uk
  Daejeon 34122 (KR)
• CHOI, Jung Hwan
  Daejeon 34122 (KR)

(74) Representative: Goddar, Heinz J.
Boehmert & Boehmert
Anwaltspartnerschaft mbB
Pettenkoferstrasse 22
80336 München (DE)

(54) BATTERY DIAGNOSIS DEVICE AND OPERATION METHOD THEREOF

(57) A battery diagnosis device according to an embodiment disclosed in the present document may comprise: an acquisition unit for acquiring open circuit voltage (OCV) data of multiple battery units; a deviation calculation unit for, on the basis of the OCV data, calculating an OCV change value of the multiple battery units in a designated time interval and calculating an OCV deviation value with respect to an average indicating a difference value between an average OCV change value of the multiple battery units and an OCV change value of a target battery unit among the multiple battery units; an exponential moving average (EMA) calculation unit for calculating an EMA deviation value by applying an EMA filter to the OCV deviation value with respect to the average of the target battery unit; and a diagnosis unit for diagnosing an abnormality of the target battery unit on the basis of the EMA deviation value.

FIG.1

**Description**

## TECHNICAL FIELD

## CROSS-REFERENCE TO RELATED APPLICATION

This application claims priority to and the benefit of Korean Patent Application No. 10-2023-0119152 filed in the Korean Intellectual Property Office on September 7, 2023, the entire content of which is incorporated herein by reference.

## TECHNICAL FIELD

Embodiments disclosed herein relate to a battery diagnosis apparatus and an operating method thereof.

## BACKGROUND ART

Recently, research and development of secondary batteries have been actively performed. Herein, the secondary batteries, which are chargeable/-dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery is generally used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

## DISCLOSURE

## TECHNICAL PROBLEM

When a short circuit or a failure of another type occurs inside a battery, the possibility of damage to devices (e.g., EV, ESS) including the battery may increase. Accordingly, there is a need for a scheme to reduce the possibility of damage to devices including a battery by detecting an abnormal state of the battery.

Conventionally, a battery cell has been diagnosed by a calculation scheme using all of a state of charge (SOC), current, capacity, and open circuit voltage (OCV) information. According to such a diagnosis method, because of use of many factors, it may be difficult to perform diagnosis when specific information out of the foregoing information is missing. This may be a big issue in the battery management system implemented with a server device that has to collect data from the vehicle, and may excessively increase memory usage. Thus, there is a need for data simplification required for battery diagnosis.

According to embodiments disclosed herein, there may be provided a battery diagnosis apparatus and an operating method thereof by which abnormality of a battery may be diagnosed merely using battery OCV data information.

Technical problems of the embodiments disclosed herein are not limited to the aforementioned technical problems, and other unmentioned technical problems would be clearly understood by those of ordinary skill in the art from the following description.

## TECHNICAL SOLUTION

A battery diagnosis apparatus according to an embodiment disclosed herein includes an obtaining unit configured to obtain open circuit voltage (OCV) data of a plurality of battery units, a deviation calculating unit configured to calculate OCV variances of the plurality of battery units in a designated time period, based on the OCV data and calculate an OCV deviation with respect to an average, which is a difference between an average OCV variance of the plurality of battery units and an OCV variance of a target battery unit among the plurality of battery units, an exponential moving average (EMA) calculating unit configured to calculate an EMA deviation by applying an EMA filter to the OCV deviation with respect to the average for the target battery unit, and a diagnosing unit configured to diagnose abnormality of the target battery unit based on the EMA deviation.

In the battery diagnosis apparatus according to an embodiment disclosed herein, the designated time period may be a time period between a first point in time before charging of a battery unit and a second point in time after the charging.

In the battery diagnosis apparatus according to an embodiment disclosed herein, the EMA filter may be configured to calculate the EMA deviation by inputting an EMA deviation for a previous period and the OCV deviation with respect to the average for the target battery unit to a designated equation.

In the battery diagnosis apparatus according to an embodiment disclosed herein, the designated equation may be Equation 1 provided below,

[Equation 1]

$$EMA_t = \alpha \cdot dOCV_t + (1-\alpha) \cdot EMA_{t-1}$$

in which $EMA_t$ indicates the EMA deviation, $\alpha$ indicates a weight value, $dOCV_t$ indicates the OCV deviation with respect to the average for the target battery unit, and $EMA_{t-1}$ indicates the EMA deviation for the previous period.

In the battery diagnosis apparatus according to an embodiment disclosed herein, the obtaining unit may be further configured to obtain time-series voltage data and time-series current data of the plurality of battery units and obtain the OCV data having a designated current value and a designated voltage range, based on the time-series voltage data and the time-series current data.

In the battery diagnosis apparatus according to an embodiment disclosed herein, the battery unit may include at least one of a battery cell, a battery module, a battery pack, or a battery rack.

The battery diagnosis apparatus according to an embodiment disclosed herein may further include an abnormality processing unit configured to perform an abnormality processing function based on an abnormality diagnosis result of each of the plurality of battery units, in which the abnormality processing function includes a notification function or a short-circuit function.

A battery diagnosis method according to an embodiment disclosed herein includes obtaining open circuit voltage (OCV) data of a plurality of battery units, calculating OCV variances of the plurality of battery units in a designated time period, based on the OCV data, calculating an OCV deviation with respect to an average, which is a difference between an average OCV variance of the plurality of battery units and an OCV variance of a target battery unit among the plurality of battery units, calculating an exponential moving average (EMA) deviation by applying an EMA filter to the OCV deviation with respect to the average for the target battery unit, and diagnosing abnormality of the target battery unit based on the EMA deviation.

In the battery diagnosis method according to an embodiment disclosed herein, the designated time period may be a time period between a first point in time before charging of a battery unit and a second point in time after the charging.

In the battery diagnosis method according to an embodiment disclosed herein, the EMA filter may be configured to calculate the EMA deviation by inputting an EMA deviation for a previous period and the OCV deviation with respect to the average for the target battery unit to a designated equation.

In the battery diagnosis method according to an embodiment disclosed herein, the designated equation may be Equation 1 provided above.

The battery diagnosis method according to an embodiment disclosed herein may further include obtaining time-series voltage data and time-series current data of the plurality of battery units, in which the obtaining of the OCV data may include obtaining the OCV data having a designated current value and a designated voltage range, based on the time-series voltage data and the time-series current data.

In the battery diagnosis method according to an embodiment disclosed herein, the battery unit may include at least one of a battery cell, a battery module, a battery pack, or a battery rack.

The battery diagnosis method according to an embodiment disclosed herein may further include performing an abnormality processing function based on an abnormality diagnosis result of each of the plurality of battery units, in which the abnormality processing function includes a notification function or a short-circuit function.

ADVANTAGEOUS EFFECTS

According to embodiments disclosed herein, data used for abnormality diagnosis of a battery may be simplified.

According to embodiments disclosed herein, the accuracy of battery low-capacity abnormality diagnosis may be improved.

In addition, various effects identified directly or indirectly through this document may be provided.

**DESCRIPTION OF DRAWINGS**

FIG. 1 is a block diagram of a battery diagnosis apparatus according to an embodiment.

FIG. 2 is a graph showing an open circuit voltage (OCV) deviation with respect to an average for a battery, calculated by a battery diagnosis apparatus according to an embodiment.

FIG. 3 is a graph showing an exponential moving average (EMA) deviation of a battery, calculated by a battery diagnosis apparatus according to an embodiment.

FIG. 4 is an operating flowchart of a battery diagnosis apparatus according to an embodiment.

## MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element).

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

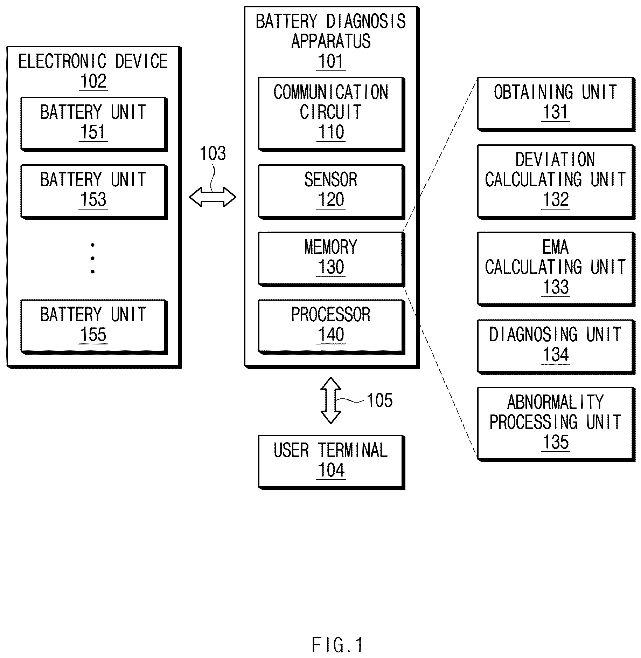

FIG. 1 is a block diagram of a battery diagnosis apparatus according to an embodiment.

The battery diagnosis apparatus 101 described below may be implemented as a battery management system (BMS) in an electronic device 102, and may also be implemented with various external devices such as a server, a cloud, a charger, a charger/discharger, etc.

Referring to FIG. 1, the battery diagnosis apparatus 101 may be wiredly and/or wirelessly connected to an electronic device 102 and a user terminal 104.

According to an embodiment, connection 103 between the battery diagnosis apparatus 101 and the electronic device 102 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (Wi-Fi), or Infrared Data Association (IrDA)) or a remote-range communication network (e.g., a cellular network, a 4th-Generation (4G) network, a 5th-Generation (5G) network).

According to another embodiment, the connection 103 between the battery diagnosis apparatus 101 and the electronic device 102 may be connection using a device-to-device communication scheme (e.g., a bus, a general-purpose input and output (GPIO), a serial peripheral interface (SPI), or a mobile industry processor interface (MIPI)).

According to an embodiment, the electronic device 102 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

According to an embodiment, the electronic device 102 may include a plurality of battery units 151, 153, and 155. According to an embodiment, the plurality of battery units 151, 153, and 155 may include at least one of a battery cell, a battery module, a battery pack, or a battery rack.

According to an embodiment, connection 105 between the battery diagnosis apparatus 101 and the user terminal 104 may be communication connection through a wired and/or wireless network.

According to an embodiment, the user terminal 104 may be a mobile device (e.g., a mobile phone, a laptop computer, a smart phone, a smart pad), or a personal computer (PC). According to an embodiment, the battery diagnosis apparatus 101 may provide information related to a diagnosis result of the battery unit 151, 153, or 155 to the user terminal 104.

According to an embodiment, the battery diagnosis apparatus 101 may include a communication circuit 110, a sensor 120, a memory 130, and a processor 140. According to an embodiment, the battery diagnosis apparatus 101 shown in FIG. 1 may further include at least one component (e.g., a display, an input device, or an output device) in addition to the components shown in FIG. 1, or at least one component (e.g., the sensor 120) among the components shown in FIG. 1 may be omitted. For example, when the battery diagnosis apparatus 101 is implemented as a separate external electronic device from the electronic device 102, such as a server, a cloud, etc., the battery diagnosis apparatus 101 may obtain state information of the plurality of battery units 151, 153, and 155 by using the communication circuit 110. In this case, the battery diagnosis apparatus 101 may not include the sensor 120.

According to an embodiment, the communication circuit 110 may establish a wired communication channel and/or a wireless communication channel between the battery diagnosis apparatus 101 and the electronic device 102 and/or the user terminal 104, and transmit and receive data to and from the electronic device 102 and/or the user terminal 104 through the established communication channel.

According to an embodiment, the sensor 120 may measure information (e.g., voltage, current, temperature, etc.,) related to states of the battery units 121, 122, and 123 of the electronic device 102. For example, when the battery diagnosis apparatus 101 is implemented as a BMS in the electronic device, the battery diagnosis apparatus 101 may directly measure states of the plurality of battery units 151, 153, and 155 by using the sensor 120.

According to an embodiment, the communication circuit 110 and/or the sensor 120 may obtain time-series data related to the states of the battery units 151, 153, and 155. In an embodiment, the time-series data related to the states of the plurality of battery units 151, 153, and 155 may include data indicating voltages, currents, resistances, states of charge (SOC), states of health (SOH), and/or temperatures with respect to time.

According to an embodiment, the memory 130 may include a volatile and/or a nonvolatile memory.

According to an embodiment, the memory 130 may store data used by at least one component (e.g., the processor 140) of the battery diagnosis apparatus 101. For example, the data may include software (or an instruction related thereto), input data, or output data. In an embodiment, the instruction, when executed by the processor 140, may cause the battery abnormality diagnosis apparatus 101 to perform operations defined by the instruction.

According to an embodiment, the memory 140 may include one or more software (e.g., an obtaining unit 131, a deviation calculating unit 132, an exponential moving average (EMA) calculating unit 133, a diagnosing unit 134, and an abnormality processing unit 135).

According to an embodiment, the processor 140 may include a central processing unit, an application processor, a graphic processing unit, a neural processing unit (NPU), an image signal processor, a sensor hub processor, or a communication processor.

According to an embodiment, the processor 140 may execute software (e.g., the obtaining unit 131, the deviation calculating unit 132, the EMA calculating unit 133, the diagnosing unit 134, and the abnormality processing unit 135) stored in the memory 130 to control at least one other component (e.g., a hardware or software component) of the battery diagnosis apparatus 101 connected to the processor 140 and perform various data processing or operations.

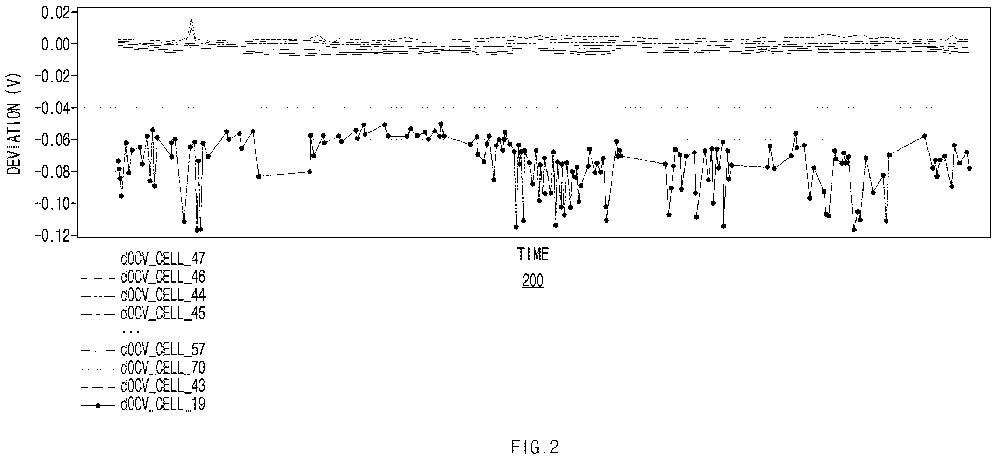

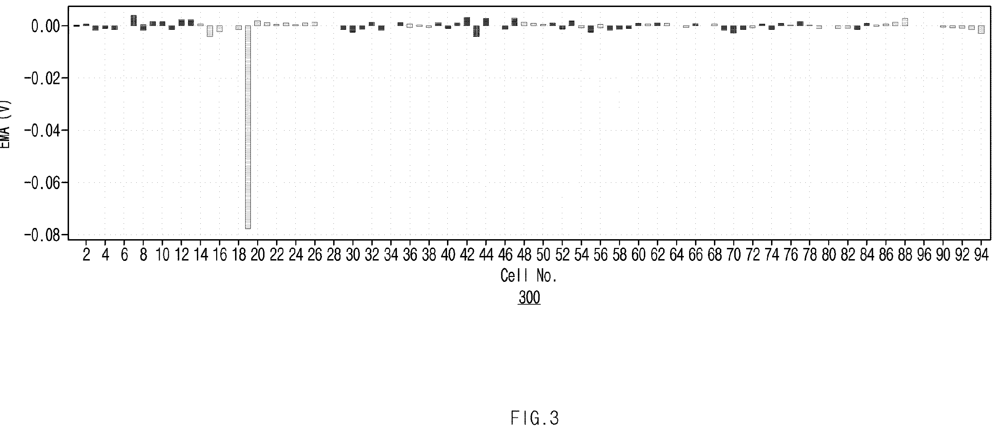

Hereinbelow, referring to FIGS. 2 and 3, a description will be made of a method, performed by the battery diagnosis apparatus 101, of diagnosing abnormality of the battery units 151, 153, and 155 through the obtaining unit 131, the deviation calculating unit 132, the EMA calculating unit 133, the diagnosing unit 134, and the abnormality processing unit 135.

FIG. 2 is a graph showing an open circuit voltage (OCV) deviation with respect to an average for a battery, calculated by a battery diagnosis apparatus according to an embodiment. FIG. 3 is a graph showing an exponential moving average (EMA) deviation of a battery, calculated by a battery diagnosis apparatus according to an embodiment.

According to an embodiment, the obtaining unit 131 may obtain OCV data of the plurality of battery units 151, 153, and 155. According to an embodiment, the obtaining unit 131 may obtain the OCV data by using the communication circuit 110 and/or the sensor 120.

According to an embodiment, the obtaining unit 131 may obtain time-series voltage data and time-series current data of the plurality of battery units 151, 153, and 155. In this case, the obtaining unit 131 may obtain the OCV data based on the time-series voltage data and the time-series current data. For example, the obtaining unit 131 may obtain, as the OCV data, data of the time-series voltage data and the time-series current data, which satisfies a designated current value (e.g., 0 A) and a designated voltage range (e.g., a voltage range of at least 3.5 V but less than 4.3 V).

According to an embodiment, the deviation calculating unit 132 may calculate an OCV deviation with respect to an average for a target battery unit 151, 153, or 155 based on the OCV data obtained by the obtaining unit 131.

According to an embodiment, the deviation calculating unit 132 may extract OCV data in a designated voltage range (e.g., 0.4 V or greater) from the OCV data. The deviation calculating unit 132 may calculate an OCV deviation with respect to an average based on the extracted OCV data in the designated voltage range.

According to an embodiment, the deviation calculating unit 132 may calculate an OCV variance in a designated time period for each of the plurality of battery units 151, 153, and 155, based on the OCV data. According to an embodiment, the designated time period may be set a time period between a first point in time before charging is performed on the battery unit 151, 153, or 155 and a second point in time after the charging is performed. For example, the deviation calculating unit 132 may calculate an OCV variance that is a difference between an OCV at the first point in time and an OCV at the second point in time, based on the OCV data of the battery unit 151, 153, or 155.

According to an embodiment, the deviation calculating unit 132 may calculate an OCV deviation with respect to the average of the target battery unit 151, 153, or 155 based on the OCV variances of the plurality of battery units 151, 153, and 155. According to an embodiment, the deviation calculating unit 132 may calculate a difference (e.g., a difference = average OCV variance - OCV variance of target battery unit) between an average OCV variance of the plurality of battery units 151, 153, and 155 and the OCV variance of the target battery unit 151, 153, or 155.

Referring to FIG. 2, a graph 200 indicating an OCV deviation with respect to an average over time for diagnosis target battery units is shown. In the graph 200, an X-axis may indicate time and a Y-axis may indicate an OCV deviation with respect to an average (a difference between an average OCV variance of diagnosis target battery units and an OCV variance of each battery unit).

According to an embodiment, the deviation calculating unit 132 may calculate an OCV deviation with respect to an average for diagnosis target battery units every designated periods. The battery diagnosis apparatus 101 may cumulatively store the OCV deviation with respect to the average, calculated by the deviation calculating unit 132, in the memory 130 during a designated time to manage OCV deviation data as shown in the graph 200.

Referring back to FIG. 1, the EMA calculating unit 133 may calculate an EMA deviation by applying an EMA filter to the OCV deviation with respect to the average for the target battery unit 151, 153, or 155, calculated by the deviation calculating unit 132.

According to an embodiment, the EMA filter may calculate an EMA deviation of the current period by inputting an EMA deviation for a previous period and an OCV deviation with respect to an average for the current period for the target battery unit 151, 153, or 155 to the designated equation. For example, the designated equation may be Equation 1 provided below.

[Equation 1]

$$EMA_t = \alpha \cdot dOCV_t + (1-\alpha) \cdot EMA_{t-1}$$

In Equation 1, $EMA_t$ refers to an EMA deviation for the current period for the target battery unit 151, 153, or 155, $\alpha$ refers to a weight value, $dOCV_t$ refers to an OCV deviation with respect to an average for the current period for the target battery unit 151, 153, or 155, and $EMA_{t-1}$ refers to an EMA deviation for the previous period for the target battery unit 151, 153, or 155. Herein, the weight value may be set variously according to specifications of the plurality of battery units 151, 153, and 155. For example, the weight value may be set to, but not limited to, 0.05.

Referring to FIG. 3, a graph 300 showing an EMA deviation for the current period for diagnosis target battery units is shown. In the graph 300, an X-axis indicates a battery unit number and a Y-axis indicates an EMA deviation.

Referring back to FIG. 1, the diagnosing unit 134 may diagnose abnormality of the target battery unit 151, 153, or 155 based on the EMA deviation calculated by the EMA deviation calculating unit 133. For example, the diagnosing unit 134 may diagnose a low capacity of the target battery unit 151, 153, or 155.

According to an embodiment, the diagnosing unit 134 may diagnose abnormality of the target battery unit 151, 153, or 155 by comparing the EMA deviation with a threshold previously stored in the memory 130.

According to an embodiment, the diagnosing unit 134 may diagnose abnormality of the plurality of battery units 151, 153, and 155 based on the EMA deviation of each of the plurality of battery units 151, 153, and 155.

According to an embodiment, the abnormality processing unit 135 may perform an abnormality processing function based on abnormality diagnosis results for the plurality of battery units 151, 153, and 155. Herein, the abnormality processing function may include a notification function or a short-circuit function.

According to an embodiment, the abnormality processing unit 135 may transmit the abnormality diagnosis results for the plurality of battery units 151, 153, and 155 to the user terminal 104 connected through a wired and/or wireless network.

According to an embodiment, the abnormality processing unit 135 may isolate an abnormal battery unit from the electronic device 102 based on the abnormality diagnosis results for the plurality of battery units 151, 153, and 155. Herein, isolation may include electrical and/or mechanical isolation.

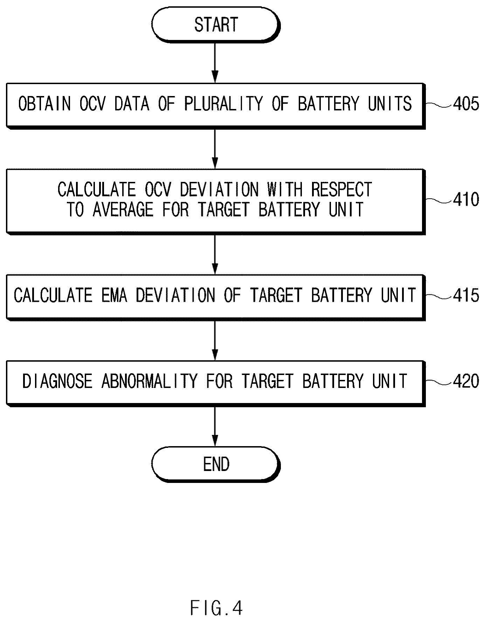

FIG. 4 is an operating flowchart of a battery diagnosis apparatus according to an embodiment. FIG. 4 will be described using the components of FIG. 1.

An embodiment shown in FIG. 4 is merely an embodiment, and an order of operations according to various embodiments of the present disclosure may be different from that shown in FIG. 4, some operations shown in FIG. 4 may be omitted, or an order of the operations may be changed or operations may be merged.

Referring to FIG. 4, in operation 405, the battery diagnosis apparatus 101 may obtain OCV data of the plurality of battery units 151, 153, and 155. According to an embodiment, the battery diagnosis apparatus 101 may obtain the OCV data by using the communication circuit 110 and/or the sensor 120.

According to an embodiment, the battery diagnosis apparatus 101 may obtain time-series voltage data and time-series current data of the plurality of battery units 151, 153, and 155. In this case, the battery diagnosis apparatus 101 may obtain the OCV data based on the time-series voltage data and the time-series current data. For example, the battery diagnosis apparatus 101 may obtain, as the OCV data, data of the time-series voltage data and the time-series current data, which satisfies a designated current value (e.g., 0 A) and a designated voltage range (e.g., a voltage range of at least 3.5 V but less than 4.3 V).

In operation 410, the battery diagnosis apparatus 101 may calculate an OCV variance in a designated time period for each of the plurality of battery units 151, 153, and 155, based on the OCV data obtained in operation 405. According to an embodiment, the designated time period may be set a time period between a first point in time before charging is performed on the battery unit 151, 153, or 155 and a second point in time after the charging is performed. For example, the deviation calculating unit 132 may calculate an OCV variance that is a difference between an OCV at the first point in time and an OCV at the second point in time, based on the OCV data of the battery unit 151, 153, or 155.

According to an embodiment, the battery diagnosis apparatus 101 may extract OCV data in a designated voltage range (e.g., 0.4 V or greater) from the OCV data. The battery diagnosis apparatus 101 may calculate the OCV deviation based on the extracted OCV data in the designated voltage range.

In operation 415, the battery diagnosis apparatus 101 may calculate an OCV deviation with respect to the average of the target battery unit 151, 153, or 155 based on the OCV variances of the plurality of battery units 151, 153, and 155, calculated in operation 410.

According to an embodiment, the battery diagnosis apparatus 101 may calculate, as the OCV deviation with respect to the average, a difference (e.g., a difference = average OCV variance - OCV variance of target battery unit) between an average OCV variance of the plurality of battery units 151, 153, and 155 and the OCV variance of the target battery unit 151, 153, or 155.

In operation 420, the battery diagnosis apparatus 101 may calculate an EMA deviation of the target battery unit 151, 153, or 155. According to an embodiment, the battery diagnosis apparatus 101 may calculate the EMA deviation by applying an EMA filter to the OCV deviation with respect to the average, calculated in operation 415.

According to an embodiment, the EMA filter may calculate an EMA deviation of the current period by inputting an EMA deviation for a previous period and an OCV deviation with respect to an average for the current period for the target battery unit 151, 153, or 155 to the designated equation. For example, the designated equation may be Equation 1 provided above.

In operation 425, the battery diagnosis apparatus 101 may diagnose abnormality of the target battery unit 151, 153, or 155 based on the EMA deviation calculated in operation 420. For example, the battery diagnosis apparatus 101 may diagnose a low capacity of the target battery unit 151, 153, or 155.

According to an embodiment, the battery diagnosis apparatus 101 may diagnose abnormality of the target battery unit 151, 153, or 155 by comparing the EMA deviation with a previously stored threshold.

According to an embodiment, the battery diagnosis apparatus 101 may diagnose abnormality of the plurality of battery units 151, 153, and 155 based on the EMA deviation of each of the plurality of battery units 151, 153, and 155.

According to an embodiment, the battery diagnosis apparatus 101 may perform an abnormality processing function based on abnormality diagnosis results for the plurality of battery units 151, 153, and 155. Herein, the abnormality processing function may include a notification function or a short-circuit function.

According to an embodiment, the battery diagnosis apparatus 101 may transmit the abnormality diagnosis results for the plurality of battery units 151, 153, and 155 to the user terminal 104 connected through a wired and/or wireless network.

According to an embodiment, the battery diagnosis apparatus 101 may isolate an abnormal battery unit from the electronic device 102 based on the abnormality diagnosis results for the plurality of battery units 151, 153, and 155. Herein, isolation may include electrical and/or mechanical isolation.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

**Claims**

**1.** A battery diagnosis apparatus comprising:

an obtaining unit configured to obtain open circuit voltage (OCV) data of a plurality of battery units;

a deviation calculating unit configured to calculate OCV variances of the plurality of battery units in a designated time period, based on the OCV data and calculate an OCV deviation with respect to an average, which is a difference between an average OCV variance of the plurality of battery units and an OCV variance of a target battery unit among the plurality of battery units;

an exponential moving average (EMA) calculating unit configured to calculate an EMA deviation by applying an EMA filter to the OCV deviation with respect to the average for the target battery unit; and

a diagnosing unit configured to diagnose abnormality of the target battery unit based on the EMA deviation.

2. The battery diagnosis apparatus of claim 1, wherein the designated time period is a time period between a first point in time before charging of a battery unit and a second point in time after the charging.

3. The battery diagnosis apparatus of claim 1, wherein the EMA filter is configured to calculate the EMA deviation by inputting an EMA deviation for a previous period and the OCV deviation with respect to the average for the target battery unit to a designated equation.

4. The battery diagnosis apparatus of claim 3, wherein the designated equation is Equation 1 provided below,

[Equation 1]

$$EMA_t = \alpha \cdot dOCV_t + (1-\alpha) \cdot EMA_{t-1}$$

wherein EMA$_t$ indicates the EMA deviation, $\alpha$ indicates a weight value, dOCV$_t$ indicates the OCV deviation with respect to the average for the target battery unit, and EMA$_{t-1}$ indicates the EMA deviation for the previous period.

5. The battery diagnosis apparatus of claim 1, wherein the obtaining unit is further configured to:

obtain time-series voltage data and time-series current data of the plurality of battery units; and

obtain the OCV data having a designated current value and a designated voltage range, based on the time-series voltage data and the time-series current data.

6. The battery diagnosis apparatus of claim 1, wherein the battery unit comprises at least one of a battery cell, a battery module, a battery pack, or a battery rack.

7. The battery diagnosis apparatus of claim 1, further comprising an abnormality processing unit configured to perform an abnormality processing function based on an abnormality diagnosis result of each of the plurality of battery units,

wherein the abnormality processing function comprises a notification function or a short-circuit function.

8. A battery diagnosis method comprising:

obtaining open circuit voltage (OCV) data of a plurality of battery units;

calculating OCV variances of the plurality of battery units in a designated time period, based on the OCV data;

calculating an OCV deviation with respect to an average, which is a difference between an average OCV variance of the plurality of battery units and an OCV variance of a target battery unit among the plurality of battery units;

calculating an exponential moving average (EMA) deviation by applying an EMA filter to the OCV deviation with respect to the average for the target battery unit; and

diagnosing abnormality of the target battery unit based on the EMA deviation.

9. The battery diagnosis method of claim 8, wherein the designated time period is a time period between a first point in time before charging of a battery unit and a second point in time after the charging.

10. The battery diagnosis method of claim 8, wherein the EMA filter is configured to calculate the EMA deviation by inputting an EMA deviation for a previous period and the OCV deviation with respect to the average for the target battery unit to a designated equation.

11. The battery diagnosis method of claim 10, wherein the designated equation is Equation 1 provided below,

[Equation 1]

$$EMA_t = \alpha \cdot dOCV_t + (1-\alpha) \cdot EMA_{t-1}$$

wherein EMA$_t$ indicates the EMA deviation, $\alpha$ indicates a weight value, dOCV$_t$ indicates the OCV deviation with respect to the average for the target battery unit, and EMA$_{t-1}$ indicates the EMA deviation for the previous period.

**12.** The battery diagnosis method of claim 8, further comprising obtaining time-series voltage data and time-series current data of the plurality of battery units,

wherein the obtaining of the OCV data comprises obtaining the OCV data having a designated current value and a designated voltage range, based on the time-series voltage data and the time-series current data.

**13.** The battery diagnosis method of claim 8, wherein the battery unit comprises at least one of a battery cell, a battery module, a battery pack, or a battery rack.

**14.** The battery diagnosis method of claim 8, further comprising performing an abnormality processing function based on an abnormality diagnosis result of each of the plurality of battery units,

wherein the abnormality processing function comprises a notification function or a short-circuit function.

ELECTRONIC DEVICE
102

BATTERY UNIT
151

BATTERY UNIT
153

⋮

BATTERY UNIT
155

103

BATTERY DIAGNOSIS
APPARATUS
101

COMMUNICATION
CIRCUIT
110

SENSOR
120

MEMORY
130

PROCESSOR
140

105

USER TERMINAL
104

OBTAINING UNIT
131

DEVIATION
CALCULATING UNIT
132

EMA
CALCULATING UNIT
133

DIAGNOSING UNIT
134

ABNORMALITY
PROCESSING UNIT
135

FIG.1

FIG.2

FIG.3

START

OBTAIN OCV DATA OF PLURALITY OF BATTERY UNITS ⌇405

CALCULATE OCV DEVIATION WITH RESPECT
TO AVERAGE FOR TARGET BATTERY UNIT ⌇410

CALCULATE EMA DEVIATION OF TARGET BATTERY UNIT ⌇415

DIAGNOSE ABNORMALITY FOR TARGET BATTERY UNIT ⌇420

END

FIG.4

## INTERNATIONAL SEARCH REPORT

| International application No. |
| --- |
| **PCT/KR2024/096082** |

| **A.** | **CLASSIFICATION OF SUBJECT MATTER** |
| --- | --- |

**G01R 31/396**(2019.01)i; **G01R 31/385**(2019.01)i; **G01R 31/392**(2019.01)i; **G01R 31/382**(2019.01)i; **G01R 31/52**(2020.01)i; **G01R 19/10**(2006.01)i; **G01R 19/00**(2006.01)i; **G01R 19/165**(2006.01)i

According to International Patent Classification (IPC) or to both national classification and IPC

| **B.** | **FIELDS SEARCHED** |
| --- | --- |

Minimum documentation searched (classification system followed by classification symbols)

G01R 31/396(2019.01); B60L 3/00(2006.01); G01R 31/36(2006.01); G01R 31/3842(2019.01); H01M 10/39(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), OCV(Open Circuit Voltage), 평균(average), EMA(Exponential Moving Average), 이상(abnormal), 진단(diagnosis)

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| Y<br><br>A | JP 4019815 B2 (NISSAN MOTOR CO., LTD.) 12 December 2007 (2007-12-12)<br>See paragraphs [0006]-[0038] and figures 1 and 5. | 1-3,5-10,12-14<br><br>4,11 |
| Y | KR 10-2021-0150290 A (TOYOTA JIDOSHA KABUSHIKI KAISHA) 10 December 2021 (2021-12-10)<br>See paragraphs [0054], [0067] and [0092], claim 5 and figure 8. | 1-3,5-10,12-14 |
| A | KR 10-1474401 B1 (LG CHEM, LTD.) 19 December 2014 (2014-12-19)<br>See paragraphs [0030]-[0073]. | 1-14 |
| A | JP 2004-247319 A (NGK INSULATORS LTD. et al.) 02 September 2004 (2004-09-02)<br>See paragraphs [0009]-[0054]. | 1-14 |
| A | US 2021-0311127 A1 (VEHICLE ENERGY JAPAN INC.) 07 October 2021 (2021-10-07)<br>See paragraphs [0033]-[0064]. | 1-14 |

☐ Further documents are listed in the continuation of Box C.  ☑ See patent family annex.

| | |
| --- | --- |
| *  Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **05 December 2024** | **05 December 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/096082**

| Patent document cited in search report | | | Publication date (day/month/year) | Patent family member(s) | | | Publication date (day/month/year) |
|---|---|---|---|---|---|---|---|
| JP | 4019815 | B2 | 12 December 2007 | JP | 2004-031120 | A | 29 January 2004 |
| | | | | US | 2004-0001996 | A1 | 01 January 2004 |
| | | | | US | 7332891 | B2 | 19 February 2008 |
| KR | 10-2021-0150290 | A | 10 December 2021 | CN | 113752840 | A | 07 December 2021 |
| | | | | CN | 113752840 | B | 30 April 2024 |
| | | | | DE | 102021114050 | A1 | 09 December 2021 |
| | | | | JP | 2021-191185 | A | 13 December 2021 |
| | | | | JP | 7508866 | B2 | 02 July 2024 |
| | | | | KR | 10-2640065 | B1 | 27 February 2024 |
| | | | | US | 11624785 | B2 | 11 April 2023 |
| | | | | US | 2021-0382119 | A1 | 09 December 2021 |
| KR | 10-1474401 | B1 | 19 December 2014 | KR | 10-1630409 | B1 | 14 June 2016 |
| | | | | KR | 10-2012-0119598 | A | 31 October 2012 |
| JP | 2004-247319 | A | 02 September 2004 | | None | | |
| US | 2021-0311127 | A1 | 07 October 2021 | CN | 112912747 | A | 04 June 2021 |
| | | | | CN | 112912747 | B | 11 July 2023 |
| | | | | EP | 3832331 | A1 | 09 June 2021 |
| | | | | EP | 3832331 | B1 | 02 August 2023 |
| | | | | JP | 6947937 | B2 | 13 October 2021 |
| | | | | US | 12117497 | B2 | 15 October 2024 |
| | | | | WO | 2020-026509 | A1 | 06 February 2020 |

Form PCT/ISA/210 (patent family annex) (July 2022)

**EP 4 671 798 A1**

**Patent documents cited in the description**

- KR 1020230119152